Europäisches Patentamt

European Patent Office

Office européen des brevets

(19)

(11) Veröffentlichungsnummer: **0 056 433**
**B1**

(12) # EUROPÄISCHE PATENTSCHRIFT

(45) Veröffentlichungstag der Patentschrift:
**17.01.90**

(51) Int. Cl. ⁴: **G 11 C 11/24**

(21) Anmeldenummer: **81108510.9**

(22) Anmeldetag: **19.10.81**

(54) Leseschaltung für einen monolithisch integrierten Halbleiterspeicher.

(30) Priorität: **19.01.81 DE 3101520**

(43) Veröffentlichungstag der Anmeldung:
**28.07.82 Patentblatt 82/30**

(45) Bekanntmachung des Hinweises auf die Patenterteilung:
**17.01.90 Patentblatt 90/03**

(84) Bennante Vertragsstaaten:
**DE FR GB**

(56) Entgegenhaltungen:
**US-A-3 879 621**
**US-A-4 070 590**
**US-A-4 169 233**
**US-A-4 195 357**

**PATENTS ABSTRACTS OF JAPAN, 1978, Seite 4126 E
78; & JP - A - 53 54 430 (NIPPON DENKI k.K.)
17.05.1978**

**PATENTS ABSTRACTS OF JAPAN, Band 3, Nr. 135 (E-
50), 10. November 1979, Seite 41 E 150; & JP - A - 54
112 131 (NIPPON DENKI K.k.) 01-09-1979**

**PATENTS ABSTRACTS OF JAPAN, Band 4, Nr. 70 (P-
12) 552 , 23. Mai 1980, Seite 145 P 12; & JP - A - 55 38
611 (NIPPON DENKI K.K.) 18.03.1980**

(73) Patentinhaber: **Siemens Aktiengesellschaft
Wittelsbacherplatz 2
D-8000 München 2 (DE)**

(72) Erfinder: **Hoffmann, Kurt, Dr.-Ing.
Neikenweg 20
D-8021 Taufkirchen (DE)**

LIBERGRAF, STOCKHOLM 1990

## Beschreibung

Die Erfindung betrifft eine Leseschaltung in einem monolithisch integrierten Halbleiterspeicher nach dem Obergriff des Patentanspruches 1.

Aus der US-A-4 169 233 ist eine Leseschaltung bekannt mit zwei kreuzgekoppelten CMOS-Invertern, mit zwei Transfergates zur getakteten Ankopplung von Bitleitungsabschnitten an die Leseschaltung und mit zwei zueinander komplementären Transistoren zum getakteten Zuführen von Versorgungspotentialen an die Leseschaltung.

Aus der JP-A-5 354 430 ist eine Leseschaltung bekannt, die als reine n-Kanal-Schaltung aufgebaut ist. Sie enthält zwei kreuzgekoppelte Transistoren, zwei getaktete Schalteinrichtungen zur Zuführung von Versorgungspotentialen, zwei Barrieretransistoren zur Ankopplung der Leseschaltung an Bitleitungsabschnitte sowie einen Transistor zum Ladungsausgleich zwischen den Bitleitungsabschnitten. Die Schalteinrichtungen zur Zuführung der Versorgungspotentiale werden zu verschiedenen Zeitpunkten aktiviert. Der Transistor zum Ladungsausgleich ist genau dann aktiviert, wenn das eine Versorgungspotential an die Leseschaltung angelegt ist. Die Gates der Barrieretransistoren sind offensichtlich mit einem festen Potential verbunden.

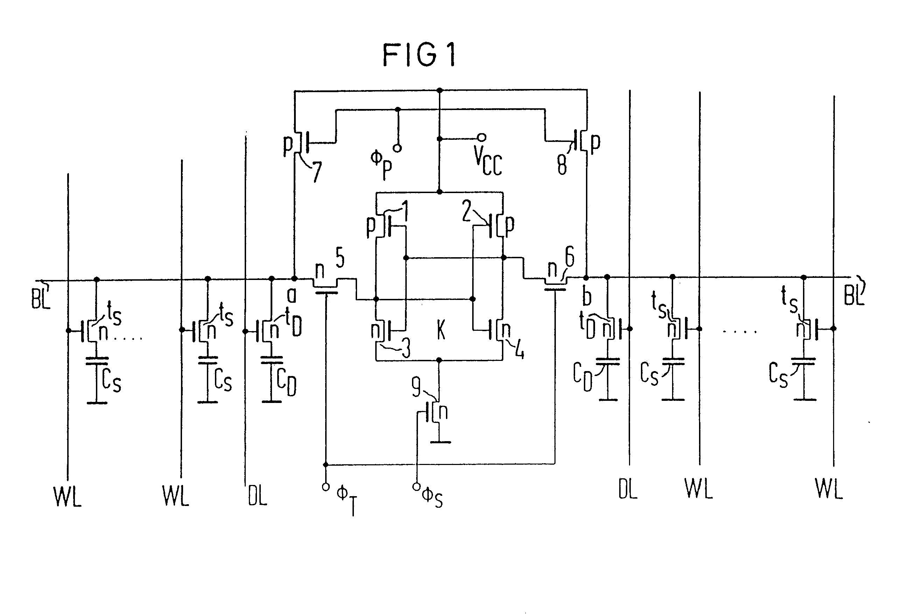

Bei der üblichen Organisation bekannter dynamischer RAM-Speicher ist jeder Spalte der Speichermatrix je ein als Differenzverstärker wirksamer Komparator zugeteilt, der sich in der Mitte der betreffenden Spalte befindet und durch eine bistabile Kippstufe gegeben ist. Die eine Hälfte der insgesamt pro Spalte vorgesehenen Ein-Transistor-Speicherzellen ist mit ihrem Drainanschluß an den einen Eingang und die andere Hälfte in derselben Weise an den anderen Eingang des Komparators angeschaltet. Weiterhin sind in jeder Spalte zwei Vergleichszellen also sog. Dummy-Zellen - vorgesehen, die in derselben Weise wie die eigentlichen Speicherzellen an je einen der beiden Eingänge des zugehörigen Komparators gelegt sind. Verwendet man, wie üblich, für die den einzelnen Matrixzeilen jeweils zugeordneten und mit den Gateelektroden der zu der betreffenden Matrixzeile gehörenden Ein-Transistor-Speicherzellen verbundenen und zeilenparallel geführten Leitung die übliche Bezeichnung "Wortleitung" und für die den einzelnen Matrixspalten jeweils zugeordnete und parallel zu dieser verlaufende Leitung die übliche Bezeichnung "Bitleitung", so kann mann die Situation, wie folgt, definieren: Jede Bitleitung BL der Speichermatrix ist halbiert und die eine Hälfte an den einen Signaleingang und die andere Hälfte an den anderen Signaleingang des jeweils zuegörigen Komparators K gelegt. Die pro Spalte vorgesehene Anzahl der Ein-Transistor-Speicherzellen ist dementsprechend ebenfalls halbiert, wobei die eine Hälfte am einen und die andere Hälfte am anderen Signaleingang des Komparators K liegt, wie dies auch aus der noch zu beschreibenden Fig. 1 erkennbar ist. Der der betreffenden Bitleitung BL abgewandte spannungsführende Anschluß des MOS-Transistors der einzelnen Ein-Transistor-Speicherzelle ist über den Speicherkondensator der betreffenden Zelle an das Bezugspotential (Masse) oder stattdessen an das andere Betriebspotential (Vcc) gelegt.

Eine solche Speicherschaltung ist z. B. in "1978 IEEE International Solid-State Circuits Conference", S. 156 und 157, (vgl. z. B. Fig. 1 in dieser Literaturstelle) dargestellt.

Bei den bekannten Speichern mit Ein-Transistor-Speicherzellen ist der Komparator K in der Regel aus Transistoren vomselben Typ, wie er bei den Transistoren der Ein-Transistor-Speicherzellen angewendet ist, aufgebaut. Man kann deshalb den Komparator K ohne zusätzlichen Dotierungsaufwand gemeinsam mit den übrigen Transistoren des Speichers herstellen.

Andererseits waren sog. CMOS-Speicher bekannt (vgl. proc. IEEE (July 1971), S. 1044 - 1058; insbes. S. 1054, Fig. 17), die als Speicherzellen sog. Sechs-Transistor-Zellen verwenden. Diese Speicherzellen sind aus jeweils zwei in CMOS-Technik ausgeführten Invertern zusammengesetzt, die ihrerseits aus der Serienschaltung eines p-Kanal-Transistors und eines n-Kanal-Transistors (beide vom Anreicherungstyp) bestehen. Die Gates dieser beiden komplementären MOS-Transistoren des einzelnen Inverters bilden gemeinsam den Signaleingang des Inverters, während der sein Signalausgang durch einen Schaltungspunkt zwischen den in Serie liegenden Source-Drainstrecken der beiden Transistoren des Inverters gegeben ist. Die beiden Inverter liegen nun z. B. mit dem anderen Anschluß ihrer Source-Drainstrecke an dem einen Pol, z. B. dem positiven Pol einer Gleichspannungsquelle und erhalten dort das Potential Vcc, während der zweite Anschluß der Source-Drainstrecke des jeweils zweiten Transistors, also z. B. des n-Kanal-Transistors der beiden Inverter am anderen, z. B. am negativen Pol der besagten Gleichspannungsquelle angeschlossen ist. Schließlich liegen die beiden Gates des ersten Inverters am Signalausgang des zweiten Inverters und die beiden Gates des zweiten Inverters der Speicherzelle am Signalausgang des ersten Inverters, wodurch die angestrebte Flip-Flopwirkung und damit die Speicherfähigkeit der Zelle bedingt ist. Abschließend ist noch zu bemerken, daß die durch die Ausgänge der beiden Inverter gegebenen Anschlüsse der Zelle über die Source-Drainstrecke je eines n-Kanal-MOS-Feldeffekttransistors vom Anreicherungstyp an je eine der die betreffende Flip-Flop-Speicherzelle steuernde Bit-Leitung angeschlossen ist, während die Gates dieser beiden Feldeffekttransistoren über die der betreffenden Speicherzelle zugeordnete Wortleitung gesteuert sind.

Die Aufgabe der vorliegenden Erfindung ist nun darin zu sehen die auf Basis von Ein-Transistor-Speicherzellen aufgebauten dynamischen Matrixspeicher hinsichtlich der Empfindlichkeit des Ansprechens über die Erhöhung des Wirkungsgrates seiner Komparatoren zu verbessern.

Die vorliegende Aufgabe wird bei einer gattungsgemäßen Leseschaltung gelöst durch die kennzeichnenden Merkmale des Patentanspruches 1. Vorteilhafte Aus- und Weiterbildungen sind in Unteransprüchen gekennzeichnet.

Der Ersatz der üblicherweise als Komparatoren eingesetzten und ausschließlich mit Transistoren vom Typ der in den Ein-Transistor-Speicherzellen verwendeten Transistoren ausgestatteten Flip-Flops durch einen in komplementärer MOS-Technik ausgeführten Komparator bedeutet ersichtlich eine Erhöhung des technischen Aufwandes bei der Herstellung der Speichermatrix. Der erhöhte Aufwand wird jedoch durch den erzielten Vorteil hinsichtlich der erhöhten Arbeitsgeschwindigkeit überkompensiert. Nicht unwesentlich ist ferner die Tatsache, daß ein solcher Komparator keinen erhöhten Platzbedarf im Vergleich zu den üblichen Komparatoren erfordert. Die Hauptsache ist jedoch, daß die Ansprechempfindlichkeit und damit die Ansprechgeschwindigkeit durch die Verwendung eines solchen Komparators im Vergleich zu den üblichen Standart-RAM's mit Ein-Transistor-Speicherzellen erheblich gesteigert wird.

Die Erfindung wird nun anhand der Figuren 1 bis 3 weiter vorgestellt. Dabei sind in Fig. 1 und 2 zwei bevorzugt anzuwendende Ausführungsbeispiele und in Fig. 3 das zugehörige Zeitdiagramm dargestellt.

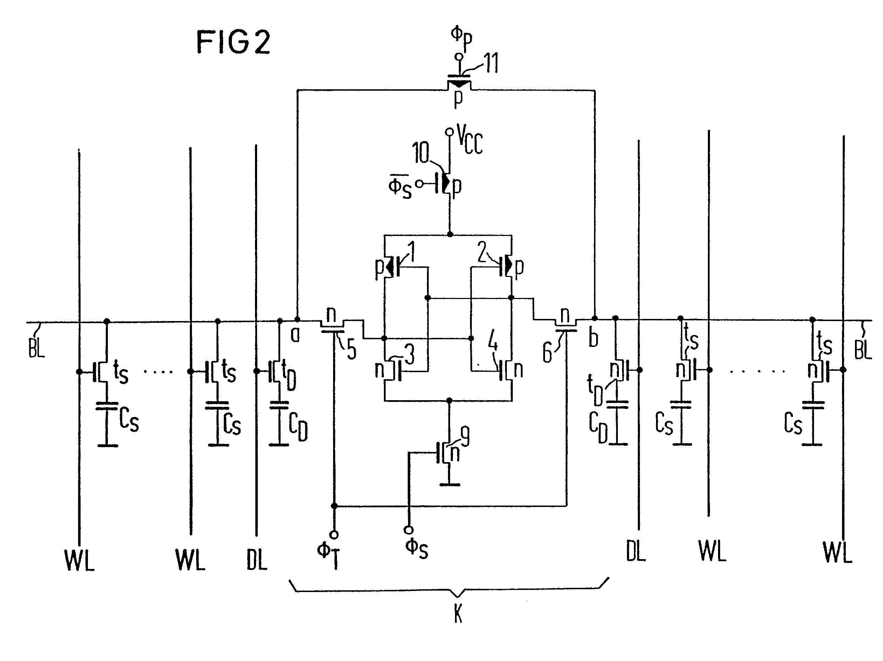

Die bei den Ausgestaltungen in Fig. 1 und Fig. 2 verwendeten Ein-Transistor-Speicherzellen bestehen, wie bereits angedeutet, aus einem Transfer-Transistor $t_s$, dessen Drain über den der betreffenden Speicherzelle zugeordneten Speicherkondensator $C_s$ an das Bezugspotential gelegt ist, während sein Sourceanschluß an der der betreffenden Matrixspalte und damit der betreffenden Speicherzelle jeweils zugeordneten Bitleitung BL angeschlossen ist. Üblicherweise bestehen auch hier die Ladungstransistoren oder Transfer-Transistoren $t_s$ aus einander gleichen n-Kanal MOS-FET's vom Anreicherungstyp und sind somit selbstsperrend. Das letztere gilt übrigens für alle in der Speichermatrix einschließlich der Komparatoren K verwendeten Feldeffekttransistoren.

Wie gewöhnlich ist auch hier die Zahl der der einzelnen Matrixspalte zugeordneten Speicherzellen halbiert, so daß die eine Hälfte dieser Speicherzellen $t_s$, $C_s$ über die eine Hälfte der jeweils zugeordneten Bitleitung BL mit dem informationsführenden Anschluß a und die andere Hälfte dieser Speicherzellen über die andere Hälfte der Bitleitung BL mit dem anderen informationsführenden Anschluß b des Komparators K verbunden ist. Die Gates der der einzelnen Matrixzeile jeweils zugeordneten Ein-Transistor-Speicherzellen, d.h. deren Transistoren $t_s$, liegen jeweils an einer gemeinsamen Wortleitung WL und werden über diese adressiert. Aus ersichtlichen Gründen sind die Wortleitungen WL im Gegensatz zu den Bitleitungen BL nicht halbiert.

Zusätzlich ist jede Hälfte der Bitleitungen BL mit je einer mit den einzelnen Ein-Transistorspeicherzellen $t_s$, $C_s$, übereinstimmenden Vergleich-szelle oder Dummy-Zelle $t_D$, $C_D$ versehen, die in gleicher Weise wie die eigentlichen Speicherzellen an die zugehörige Bitleitungshälfte BL angeschlossen ist. Damit liegt an jedem der beiden informationsführenden Anschlüsse a und b der vorgesehenen Komparatoren K je eine solche Vergleichszelle $t_D$, $C_D$. Die mit den Anschlüssen a der Komparatoren K verbundenen Vergleichszellen sind über eine erste, den Wortleitungen bei den eigentlichen Speicherzellen $t_s$, $C_s$ entsprechende Dummy-Leitung DL und die mit den Anschlüssen b der Komparatoren K verbunden Vergleichszellen durch eine analoge zweite Dummy-Leitung DL adressierbar.

Von den beiden informationsführenden Anschlüssen a und b der einzelnen Komparatoren K führt die Source-Drainstrecke jeweils eines n-Kanal-Feldeffekttransistors 5 bzw. 6 in das Innere des Komparators K. Der andere stromführende Anschluß dieser beiden n-Kanal-Transistoren 5 und 6 ist mit dem Ausgang des CMOS-Inverters 1, 3 und dem Eingang des CMOS-Inverters 2, 4 bzw. mit dem Ausgang des CMOS-Inverters 2, 4 und dem Eingang des CMOS-Inverters 1, 3 verbunden. Zu erwähnen ist, daß die beiden MOS-Feldeffekttransistoren 5 und 6 durch ein gemeinsames Taktsignal $\Phi_T$ gesteuert sind und ggf. auch als p-Kanal-MOS-FET's realisiert sein können.

Die beiden Inverter 1, 3 und 2, 4 entsprechen im Aufbau den bekannten CMOS-Speicherzellen, wobei im Beispielsfall die beiden Transistoren 1 und 2 vom p-Kanaltyp und die beiden Transistoren 3 und 4 vom n-Kanaltyp sind. Beide Transistoren 1 und 2 einerseits und beide Transistoren 3 und 4 sind jeweils über ihre Sourceanschlüsse miteinander verbunden und werden über diese durch je eines der beiden für die Schaltung vorgesehenen Betriebspotentiale $V_{CC}$ bzw. das Bezugspotential (Masse) beaufschlagt. Anderseits sind die Drains der beiden Transistoren 1 und 3 einerseits über den n-Kanaltransistor 5 an den informationsführenden Anschluß a und die Drains der beiden Transistoren 2 und 4 andererseits über den n-Kanaltransistor an den informationsführenden Anschluß b des Komparators K gelegt. Schließlich ist zur Erzielung der Flip-Flopwirkung eine Kreuzkopplung vorgesehen, indem die Drains der Transistoren 2 und 4 mit den Gates der Transistoren 1 und 3 sowie die Drains der Transistoren 1 und 3 mit den Gates der Transistoren 2 und 4 verbunden sind.

Gemeinsam ist beiden Ausführungen gemäß Fig. 1 und Fig. 2 noch, daß zwischen dem das Bezugspotential liefernden Versorgungsanschluß, also den Sourceanschlüssen der beiden n-Kanaltransistoren 3 und 4 des Komparators K die Source-Drainstrecke eines weiteren n-Kanal-MOS-FET's 9 gelegt ist. Dieser wird durch ein weiteres Taktsignal $\Phi_S$ gesteuert.

Soweit wie bisher beschrieben, stimmen die beiden Schaltungen gemäß Figur 1 und Figur 2 überein. Abweichungen hingegen gibt es hinsichtlich einer außerhalb des Flip-Flops 1, 2, 3, 4 verlaufenden weiteren Verbindung zwischen den beiden informationsführenden Anschlüssen a und b des Komparators K sowie inbezug auf die Anschaltung des Flip-Flops an das erste Betriebspotential V$_{CC}$.

Im Falle einer Ausführung gemäß Figur 1 sind
die beiden informationstragenden Anschlüsse a
und B des Komparators K über die Serienschaltung zweier p-Kanal MOS-FET's 7 und 8 miteinander verbunden. Die Gates dieser beiden Transistoren 7 und 8 werden gemeinsam durch ein
drittes Taktsignal p gesteuert. Außerdem liegt der
das erste Betriebspotential V$_{CC}$ liefernde Versorgungsanschluß sowohl an den Sourceanschlüssen der beiden p-Kanaltransistoren 1 und 2 des
Flip-Flops des Komparators K als auch als auch
an einem Schaltungspunkt zwischen den Source-
Drainstrecken der beiden hintereinandergeschalteten p-Kanaltransistoren 7 und 8, wie dies aus
Fig. 1 ersichtlich ist.

Aufgrund der in Fig. 1 dargestellten Schaltungsweise werden ersichtlich die Bitleitungen BL
auf das V$_{CC}$-Potential vorgeladen. Andererseits
kann aber auch eine Ausgestaltung von Interesse
sein, bei der die Bitleitungen auf das Potential
1/2·V$_{CC}$ vorgeladen werden.

Letzteres ist bei der in Fig. 2 dargestellten
Schaltungsweise der Fall. Bei der in Figur 2 dargestellten Ausführungsform ist statt der in Figur 1
dargestellten Variante in der Verbindung zwischen den beiden informationstragenden Anschlüssen a und b des Komparators K nur ein
einziger MOS-FET 11 vorgesehen, der ebenfalls
vom p-Kanaltyp ist und von einem Taktsignal Φ$_p$
gesteuert wird, das dem für die Steuerung der
p-Kanaltransistoren 7 und 8 bei einer Schaltung
gemäß Fig. 1 zu verwendenden Taktsignal Φ$_p$
entspricht. Außerdem ist bei der Ausgestaltung
gemäß Fig. 2 auch das erste Betriebspotential
V$_{CC}$ nicht unmittelbar an das den Komparator K
bildende Flip-Flop 1, 2, 3 und 4 gelegt. Vielmehr
ist in Abweichung von Fig. 1 auch hier ein Schalttransistor 10 entsprechend dem Schalttransistor 9
vorgesehen, der jedoch im Gegensatz zum
Schalttransistor 9 vom p-Kanaltyp ist und von
einem Taktsignal gesteuert wird, das zu dem den
Transistor 9 steuernden Taktsignal Φ$_s$ invertiert
und deshalb mit $\overline{Φ}_s$ bezeichnet ist.

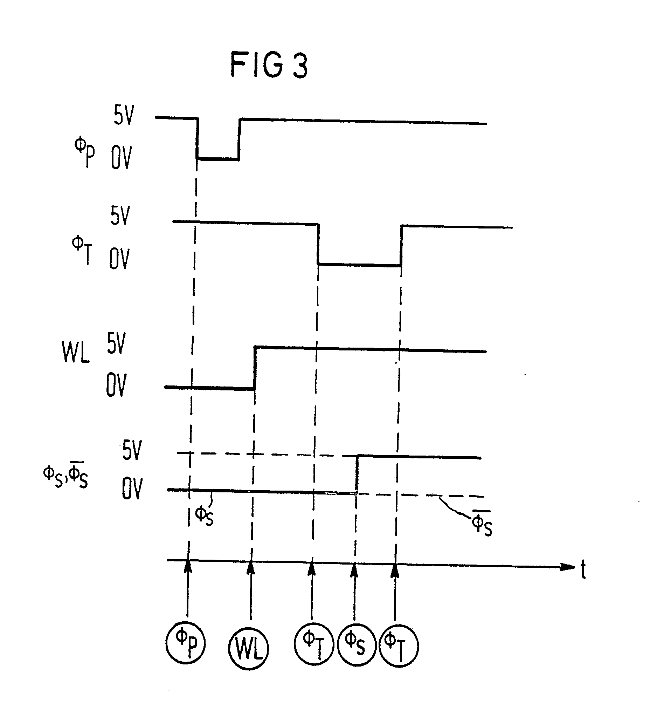

Das Zeitdiagramm für die Taktsteuerung des
Komparators K ist in Figur 3 dargestellt. Die
Impulse Φ$_s$, Φ$_T$, Φ$_P$ und WL sind Taktimpulse, die
auch beim Betrieb der bekannten dynamischen
RAM-Speicher eingesetzt werden. Dort und auch
hier dient die Impulsfolge Φ$_s$ der Aktivierung des
Komparators K und die Impulsfolge Φ$_T$ der Abtrennung bzw. Anschaltung der Bitleitungen BL
an den Komparator K, die Impulsfolge Φ$_p$ der
Vorladung der Bitleitungen BL und die Impulsfolge WL der Ansteuerung der Wortleitungen. Die
bei einer Schaltung gemäß Fig. 2 zur Steuerung
des Schalttransistors 10 vorgesehene und zu
Signal Φ$_s$ invertierte Signal $\overline{Φ}_s$.

Zu bemerken ist, daß die beiden Schalttransistoren 9 und 10 zugleich mehreren Komparatoren
K und damit Matrixspalten zugleich zugeordnet
werden können, so daß auch in dieser Hinsicht
ein Vereinfachung und damit Platzersparnis möglich ist. Zu bemerken ist ferner, daß bei einer
Anordnung gemäß der Erfindung auch die Gesamtheit der pro Spalte vorgesehenen Speicherzellen t$_S$, C$_S$ lediglich am gleichen Eingang des
Komparators K, z. B. am Eingang a angeschaltet
werden kann, so daß am anderen Eingang b lediglich die der betreffenden Spalte zugeordnete
Dummy-Zelle angeschlossen ist.

## Patentansprüche

1. Als verstärkender Komparator (K) ausgelegte
Leseschaltung in einem monolithisch integrierten
Halbleiterspeicher, mit wenigstens acht MOS-
Feldeffekttransistoren (1 bis 6, 9, 10) unterschiedlichen Kanaltyps gemäß folgender Anordnung:

- Vier erste Transistoren (1 bis 4) bilden ein
  Flip-Flop (1 bis 4), das zwei zueinander
  kreuzgekoppelte CMOS-Inverter (1, 3; 2, 4)
  enthält,
- das Flip-Flop (1 bis 4) ist informationsführungsmäßig mittels des fünften (5) und sechsten (6) jeweils als Transfertransistor angeordneten Transistors mit je einer Hälfte einer Bitleitung (BL) verbunden unter Bildung informationsführender Anschlüsse (a, b) der Leseschaltung,
- ein erster Versorgungsspannungsanschluß
  des Flip-Flop ist über einen siebten Transistor
  (9) an das Bezugspotential der Leseschaltung
  ankoppelbar,
- ein zweiter Versorgungsspannungsanschluß
  des Flip-Flops ist über einen achten Transistor (10) an das Versorgungspotential (V$_{CC}$)
  der Leseschaltung ankoppelbar,
- der siebte und der achte Transistor (9, 10)
  sind voneinander entgegengesetztem Kanaltyp und von ersten Taktsignalen (Φ$_s$, $\overline{Φ}_s$) gesteuert, die einen zueinander komplementären zeitlichen Verlauf aufweisen, *gekennzeichnet durch* folgende Merkmale:
- de Transfertransistoren (5, 6) sind durch ein
  zweites Taktsignal (Φ$_T$) gesteuert,
- zu Beginn des Ankoppelns der Versorgungsspannungsanschlüsse des Flip-Flops an das
  Bezugspotential und das Versorgungsspannungspotential (V$_{CC}$) sind die Hälften der
  Bitleitung (BL) durch das zweite Taktsignal
  (Φ$_T$) mittels der Transfertransistoren (5, 6)
  vom Flip-Flop (1 bis 4) abgekoppelt,
- die beiden informationsführenden Anschlüsse
  (a, b) der Leseschaltung sind, um einen Potentialausgleich zwischen den beiden Hälften
  der Bitleitung (BL) während einer Vorladephase zu ermöglichen, über einen durch ein
  drittes Taktsignal (Φ$_P$) gesteuerten Vorladetransistor (11) miteinander verbunden.

2. Leseschaltung nach Anspruch 1, *dadurch
gekennzeichnet*, daß der Kanaltyp der Transfertransistoren (5, 6) entweder vom Kanaltyp der
durch das Bezugspotential beaufschlagten ersten MOS-Feldeffekttransistoren (3, 4) oder vom Kanaltyp der durch das Versorgungspotential (Vcc) beaufschlagten ersten MOS-Feldeffekttransistoren (1, 2) des Flip-Flops (1 bis 4) ist.

3. Leseschaltung nach Anspruch 1 oder 2, *dadurch gekennzeichnet*, daß die Transfertransistoren (5, 6) entweder beide vom n-Kanal-Typ oder beide vom p-Kanal-Typ sind, daß außerdem die dem Bezugspotential zugewendeten ersten MOS-Feldeffekttransistoren (3, 4) des Flip-Flops (1 bis 4) sowie der siebte Transistor (9) ebenfalls vom n-Kanal-Typ sind und daß die übrigen Transistoren (1, 2; 10; 11) vom P-Kanal-Typ sind.

## Claims

1. Reading circuit designed as an amplifying comparator (K) in a monlithic integrated semiconductor memory, having at least eight (MOS) field-effect transistors (1 to 6, 9, 10) of different channel type in accordance with the following arrangement:

– four first transistors (1 to 4) from a flip-flop (1 to 4) containing two mutually cross-coupled CMOS inverters (1, 3; 2, 4),
– the flip-flop (1 to 4) is connected with respect to information carrying by means of the fifth (5) and sixth (6) transistor arranged in each case as a transfer transistor to each half of a bit line (BL), with formation of information-carrying connections (a, b) of the reading circuit,
– a first supply voltages terminal of the flip-flop can be coupled via a seventh transistor (9) to the reference potential of the reading circuit,
– a second voltage terminal of the flip-flop can be coupled via an eight transistor (10) to the supply potential (Vcc) of the reading circuit,
– the seventh and the eight transistor (9, 10) are of the opposite channel type to one another and are controlled by first clock signals ($\Phi_s$, $\overline{\Phi}_s$) which have a mutually complementary temporal curve, characterized by the following features:
– the transfer transistors (5, 6) are controlled by a second clock signal ($\Phi_T$),
– at the commencement of coupling of the supply voltages terminals of the flip-flop to the reference potential and to the supply voltage potential (Vcc), the halves of the bit line (BL) are decoupled by the second clock signal ($\Phi_T$) from the flip-flop (1 to 4) by means of the transfer transistors (5, 6),
– the two information-carrying connections (a, b) of the reading circuit are, in order to permit a potential compensation between the two halves of the bit line (BL) during a precharging phase, mutually connected via a precharging transistor (11) controlled by a third clock signal ($\Phi_P$).

2. Reading circuit according to claim 1, characterized in that the channel type of the transfer transistors (5, 6) is either of the channel type of the first MOS field-effect transistors (3, 4) receiving the reference potential or of the channel type of the first MOS field-effect transistors (1, 2), receiving the supply potential (Vcc), of the flip-flop (1 to 4).

3. Reading circuit according to claim 1 or 2, characterized in that the transfer transistors (5, 6) are either both of the n-channel type or both of the p-channel type, in that in addition the first MOS field-effect transistors (3, 4) of the flip-flop (1 to 4) devoted to the reference potential, as well as the seventh transistor (9) are likewise of the n-channel type, and in that the remaining transistors (1, 2; 10, 11) are of the P-channel type.

## Revendications

1. Circuit de lecture agencé à la manière d'un comparateur amplificateur (K) situé dans une mémoire intégrée monolithique à semi-conducteurs, comportant au moins huit transistors à effet de champ MOS (1 à 6, 9, 10) possédant des canaux de types différents, disposés conformément à l'agencement suivant:

– quatre premiers transistors (1 à 4) forment une bascule bistable (1 à 4), qui contient deux inverseurs CMOS (1, 3; 2, 4) couplés selon un couplage croisé,
– la bascule bistable (1 à 4) est raccordée, du point de vue de la transmission des informations, à l'aide des cinquième et sixième transistors (5, 6), montés respectivement en tant que transistors de transfert, à une moitié respective d'une ligne de transmission de bits (BL), moyennant la formation de bornes (a, b), transmettant les informations, du circuit de lecture,
– une première borne, recevant la tension d'alimentation, de la bascule bistable peut être couplée par l'intermédiaire d'un septième transistor (9) au potentiel de référence du circuit de lecture,
– une seconde borne, recevant la tension d'alimentation, de la bascule bistable peut être couplée par l'intermédiaire d'un huitième transistor (10) au potentiel d'alimentation (Vcc) du circuit de lecture,
– les septième et huitième transistors (9, 10) possèdent des canaux de types opposés et sont commandés par les premiers signaux de cadence ($\Phi_s$, $\overline{\Phi}_s$), qui possèdent des variations dans le temps complémentaires l'une de l'autre, remarquable par les caractéristiques suivantes:
– les transistors de transfert (5, 6) sont commandés par un second signal de cadence ($\Phi_T$),
– au début de l'accouplement des bornes, raccordées à la tension d'alimentation, de la bascule bistable au potentiel de référence et au potentiel de tension d'alimentation (Vcc), les moitiés de la ligne de transmission de bits (BL) sont découplées de la bascule bistable (1 à 4) par le second signal de cadence ($\Phi_T$), au moyen des transistors de transfert (5, 6),

— les deux bornes (a, b), transmettant les informations, du circuit de lecture sont reliées entre elles par l'intermédiaire d'un transistor de précharge (11) commandé par un troisième signal de cadence ($\Phi_P$), en vue de permettre une égalisation du potentiel entre les deux moitiés de la ligne de transmission de bits (BL) pendant une phase de précharge.

2. Circuit de lecture suivant la revendication 1, caractérisé par le fait que le type des canaux des transistors de transfert (5, 6) est soit le type du canal des premiers transistors à effet de champ MOS (3, 4) chargés par le potentiel de référence, soit le type du canal des premiers transistors à effet de champ MOS (1, 2) de la bascule bistable (1 à 4), chargés par le potentiel d'alimentation (Vcc).

3. Circuit de lecture suivant la revendication 1 ou 2, caractérisé par le fait que les transistors de transfert (5, 6) sont tous les deux du type à canal n ou du type à canal P, qu'en outre, les premiers transistors à effet de champ MOS (3, 4) de la bascule bistable (1 à 4), situés du côté du potentiel de référence, ainsi que le septième transistor (9) sont également du type à canal n et que les autres transistors (1, 2; 10, 11) sont du type à canal P.

# FIG 1

EP 0 056 433 B1

FIG 2

# FIG 3